# EUROPÄISCHE PATENTANMELDUNG

(11) **EP 2 288 241 A1**
(43) Veröffentlichungstag der Anmeldung: **23.02.2011**
(21) Anmeldenummer: 10171589.4
(22) Anmeldetag: 02.08.2010
(51) Int. Cl.: H05K 3/34

(54) **Elektrische Anschlussanordnung, Verfahren zu deren Herstellung sowie deren Verwendung**

(30) Priorität: 04.08.2009 DE 102009036025
(71) Anmelder: SIEMENS AKTIENGESELLSCHAFT, 80333 München (DE)
(72) Erfinder: Viertler, Rainer, 85591 Vaterstetten (DE)

(57) **Zusammenfassung**

Die Erfindung betrifft eine elektrische Anschlussanordnung (1, 1') auf einer Leiterplatte (2), welche mindestens eine von einer Vorderseite (2a) zu einer Rückseite (2b) der Leiterplatte (2) durchgehende Bohrung (2c) aufweist, umfassend eine mit der Rückseite (2b) der Leiterplatte (2) verlötete Mutter (3), welche lediglich an einem ersten Ende (3a) ihrer beiden Enden (3a, 3b) einen Außendurchmesser aufweist, der kleiner ist als ein Durchmesser der Bohrung (2c), wobei das erste Ende (3a) in der Bohrung (2c) angeordnet ist und wobei ein zweites Ende (3b) der beiden Enden (3a, 3b) der Mutter (3) auf der Rückseite (2b) der Leiterplatte (2) angeordnet ist. Die Erfindung betrifft weiterhin ein Verfahren zur Herstellung einer solchen elektrischen Anschlussanordnung und deren Verwendung.

## Beschreibung

### Beschreibung

Elektrische Anschlussanordnung, Verfahren zu deren Herstellung sowie deren Verwendung

Die Erfindung betrifft eine elektrische Anschlussanordnung auf einer Leiterplatte, welche mindestens eine von einer Vorderseite zu einer Rückseite der Leiterplatte durchgehende Bohrung aufweist, ein Verfahren zur Herstellung mindestens einer solchen elektrischen Anschlussanordnung sowie deren Verwendung.

Es sind bereits elektrische Anschlussanordnungen bekannt, die dazu geeignet sind, einen schichtförmigen Leiterzug auf einer Leiterplatte mit einem elektrischen Anschlussende eines elektrischen Bauelements, insbesondere der Leistungselektronik, das aufgrund seiner Abmessungen nicht für eine direkte Verbindung mit dem Leiterzug geeignet ist, wie beispielsweise einem Kabelschuh oder einem Bereich eines Metallgehäuses, zu verbinden. Als elektrisches Bauelement wird hierbei beispielsweise ein elektrisches Anschlusskabel, ein Leistungshalbleiterbauelement usw. angesehen.

So werden metallische Verbindungsstücke, mit denen elektrische Bauelement elektrisch leitend verbunden werden, beispielsweise in die Leiterplatte eingepresst, eingesteckt, mittels einer Oberflächenmontage, auch als SMT (= surfacemounting technology) bekannt, oder mittels einer Durchsteckmontage, auch als THT (= through-hole technology) bekannt, befestigt.

Die DE 1 983 582 offenbart zum einen eine elektrische Anschlussanordnung, bei der Hohlniete in eine Bohrung in der Leiterplatte eingesetzt und mit dieser beidseitig vernietet werden. Die elektrische Verbindung des Hohlniets mit dem Leiterzug der Leiterplatte wird durch Schwalllöten ausgebildet. Nach der Schwalllötung wird durch das Hohlniet eine Schraube gesteckt, mit welcher, unter Verwendung von Unterlegscheiben oder Abstandsstücken und einer Mutter, z.B. ein Kabelschuh oder ein Transistorgehäuse an der Leiterplatte befestigt wird.

Weiterhin offenbart die DE 1 983 582 eine elektrische Anschlussanordnung, bei der eine Buchse bis zu einem Anschlag in eine Bohrung in der Vorderseite einer Leiterplatte gesteckt wird. Die Buchse ragt dabei über die Rückseite der Leiterplatte hinaus und wird dort vernietet und verlötet. Die Buchse weist in ihrem auf der Vorderseite der Leiterplatte angeordneten Abschnitt ein Innengewinde auf, mit welchem ein auf der Vorderseite der Leiterplatte angeordnetes Anschlussende eines elektrischen Bauelements verschraubt wird.

Im Hinblick auf einen zunehmenden Kostendruck bei den Bauteil- und Montagekosten auf Baugruppen- und Geräteebene werden langfristig eine Vereinfachung der Fertigung und eine Steigerung der Betriebssicherheit bei der Fertigung und Anwendung solcher elektrischer Anschlussanordnungen angestrebt.

Es ist daher Aufgabe der Erfindung, eine dahingehend verbesserte elektrische Anschlussanordnung und ein Verfahren zu deren Herstellung bereitzustellen.

Die Aufgabe wird für ein Verfahren zur Herstellung mindestens einer elektrischen Anschlussanordnung auf einer Leiterplatte, welche mindestens eine von einer Vorderseite zu einer Rückseite der Leiterplatte durchgehende Bohrung aufweist, mittels folgender Schritte gelöst:
a) Aufbringen einer Lötpastenschicht in mindestens einem Bereich der Rückseite der Leiterplatte, welcher die mindestens eine Bohrung ringförmig umgibt;
b) Bestücken der Leiterplatte mit einer Mutter, welche lediglich an einem ersten Ende ihrer beiden Enden einen Außendurchmesser aufweist, der kleiner ist als ein Durchmesser der Bohrung, derart, dass das erste Ende in der Bohrung angeordnet wird; und
c) Ausbilden einer Lötverbindung zwischen der Mutter und der Leiterplatte mittels Reflow-Lötens.

Der Begriff "Reflow-Löten" ist dem Fachmann hinreichend bekannt und bezeichnet ein Aufschmelzen des in der Lötpaste enthaltenen Lotes unter Ausbildung einer Lötverbindung, in diesem Fall zwischen der Mutter und der Rückseite der Leiterplatte. Dabei wird die Mutter entweder nur mechanisch oder, sofern die Bohrung als Via fungiert, mechanisch und elektrisch leitend mit der Leiterplatte, bzw. schichtförmigen Leiterzügen in und/oder auf der Leiterplatte, verbunden.

Unter einem Bereich, der eine Bohrung "ringförmig" umgibt, wird sowohl ein Bereich verstanden, der einen geschlossenen Ring um die Bohrung bildet wie auch eine Anzahl an Teilbereichen, die einen bereichsweise unterbrochenen Ring ausbilden, der also an einer oder mehreren Stellen unterbrochen ist. Die Lötpastenschicht kann dabei unmittelbar an die Bohrung angrenzend oder mit geringem Abstand von der Bohrung aufgebracht werden. In jedem Fall muss der Bereich, in dem die Lötpastenschicht ausgebildet wird, unmittelbar an die in die Leiterplatte eingesetzte Mutter angrenzen und den überwiegenden Teil der von der Mutter bedeckten Rückseite der Leiterplatte bedecken, damit durch Reflow-Löten eine belastbare Lötverbindung zwischen der Mutter und der Leiterplatte ausgebildet werden kann.

Die Aufgabe wird für die elektrische Anschlussanordnung auf einer Leiterplatte, welche mindestens eine von einer Vorderseite zu einer Rückseite der Leiterplatte durchgehende Bohrung aufweist, gelöst, indem diese eine mit der Rückseite der Leiterplatte verlötete Mutter umfasst, welche lediglich an einem ersten Ende ihrer beiden Enden einen Außendurchmesser aufweist, der kleiner ist als ein Durchmesser der Bohrung, wobei das erste Ende in der Bohrung angeordnet ist und wobei ein zweites Ende der beiden Enden der Mutter auf der Rückseite der Leiterplatte angeordnet ist.

Er werden erfindungsgemäß elektrische Anschlussanordnungen ausgebildet, die eine verbesserte Stromtragfähigkeit bis in alle Ebenen der Leiterplatte aufweisen, in denen sich schichtförmige Leiterzüge befinden. Zudem wird eine Kostenreduzierung hinsichtlich der Bauteil- und Montagekosten erreicht. Der einfach durchzuführende Montageprozesses steigert die Betriebssicherheit in der Fertigung. Zudem wird der Anschluss von elektrischen Bauelementen an die Anschlussanordnung vereinfacht und die Qualität der elektrischen Kontaktierung vergleichmäßigt.

Dadurch, dass die Mutter auf der Rückseite der Leiterplatte mit dieser verlötet ist/wird, während die elektrischen Bauelemente auf der Vorderseite der Leiterplatte angebracht werden, wird die Druckbelastung beim Verbinden des elektrischen Bauelements mit der Mutter von der Leiterplatte selbst aufgefangen. Eine mögliche Schädigung der Lötstelle beeinträchtigt auch nicht zwingend die elektrische Kontaktierung des anzuschließenden elektrischen Bauelements, sofern dieses über die Vorderseite der Leiterplatte, beispielsweise einen darauf angeordneten schichtförmigen Leiterzug, elektrisch mit dieser verbunden ist.

Nachdem das erste Ende der Mutter nicht über die Vorderseite der Leiterplatte hinausragt, auf welcher die elektrischen Bauteile angeordnet werden sollen, wird ein solcher direkter elektrischer Anschluss eines elektrischen Bauelements, wie beispielsweise eines Kabelschuhs usw., an den auf der Vorderseite der Leiterplatte angeordneten schichtförmigen Leiterzug erst ermöglicht.

Insbesondere wird die elektrische Anschlussanordnung gemäß dem erfindungsgemäßen Verfahren gebildet.

Bevorzugt wird das erste Ende der Mutter bis zu einem Anschlag an der Mutter in die Bohrung eingebracht, wobei der Anschlag so angeordnet ist, dass das erste Ende nach dem Bestücken der Leiterplatte bereits vor Erreichen der Vorderseite der Leiterplatte endet. Das erste Ende der Mutter ist somit von der Vorderseite geringfügig zurückversetzt in der Bohrung angeordnet. Dabei ragt das erste Ende der Mutter bevorzugt mindestens 10 bis maximal 95 % der Dicke der Leiterplatte in die Bohrung hinein. Dadurch wird die Druckbelastung beim Anschluss eines elektrischen Bauelements optimal in der Leiterplatter verteilt.

Das Bestücken der Leiterplatte mit der mindestens einen Mutter erfolgt bevorzugt automatisch mittels eines Bestückungsautomaten. Eine rotationssymmetrisch ausgebildete Mutter erleichtert dabei den Einsatz eines solchen Bestückungsautomaten. Der Durchmesser der Bohrung und der Durchmesser des Abschnitts der Mutter, der in die Bohrung eingesteckt wird, sind dabei so dimensioniert, dass sich ein ringförmiger Spalt zwischen Mutter und Bohrung mit einer Spaltbreite im Bereich von 0,1 bis 0,3 mm, insbesondere von etwa 0,2 mm, ausbildet.

Nach Schritt c) wird, entweder unmittelbar nachfolgend oder nach Auslieferung der Leiterplatte inklusive elektrischer Anschlussanordnung(en) an einen Anwender, ein Anschlussende eines elektrischen Bauelements auf der Vorderseite der Leiterplatte positioniert und mit der Mutter mittels einer Schraube verschraubt. Bei dem Anschlussende handelt es sich beispielsweise um einen Kabelschuh, ein metallisches Gehäuse eines elektrischen Bauelements, usw.

Bei der elektrischen Anschlussanordnung liegt danach ein Anschlussende eines elektrischen Bauelements auf der Vorderseite der Leiterplatte angeordnet und mit der Mutter mittels einer Schraube verschraubt vor.

Um ein unbeabsichtigtes Lösen oder Lockern der Schraubverbindung zu verhindern, wird die Schraube bevorzugt mit der Mutter verklebt. Dies kann durch Auftragen eines Klebers auf das Gewinde der Schraube und/oder der Mutter, manuell oder insbesondere automatisch mittels einer SMT-Anlage oder einer Dosiervorrichtung, erfolgen.

Alternativ oder in Kombination dazu kann die Schraubverbindung mittels Sicherungs- und/oder Beilagscheiben fixiert werden.

Um eine gleichbleibende Qualität der Schaubverbindung sicherzustellen, wird bevorzugt ein definiertes Drehmoment beim Festdrehen der Schraube vorgegeben.

Bevorzugt werden die Leiterzüge der Leiterplatte, die nach der Ausbildung der Verschraubung in direktem Kontakt zum mit der Mutter verbundenen Anschlussende stehen, an ihrer Oberfläche aus dem gleichen Metall ausgebildet wie die Oberfläche des Anschlussendes, um eine elektrochemische Korrosion zu verhindern. Insbesondere werden die Oberflächen des Anschlussendes und des damit in Kontakt stehenden Bereiche eines Leiterzuges verzinnt eingesetzt.

Die Leiterplatte weist vorzugsweise eine Anzahl an Vias auf, welche auf einer die Bohrung umringenden Kreisbahn angeordnet sind. Der dem Fachmann gebräuchliche englische Begriff "Via" (= Vertical Interconnect Access) bezeichnet eine vertikale elektrische Verbindung zwischen den Leiterzugebenen einer Leiterplatte. Eine andere, weniger gebräuchliche Bezeichnung für ein Via ist die Durchkontaktierung. Zur Ausbildung eines Vias wird die Leiterplatte beispielsweise mit einer Durchbohrung geringen Durchmessers versehen und das Leiterplattenmaterial innerhalb der Durchbohrung mit einer Metallschicht belegt, die die elektrische Verbindung zwischen den an die Metallschicht angrenzenden Leiterzügen herstellt.

Die Vias dienen einer mechanischen Stabilisierung der elektrischen Anschlussanordnung und einer weiteren Erhöhung der Stromtragfähigkeit bis in alle Ebenen der Leiterplatte mit schichtförmigen Leiterzügen. Der Abstand der Vias von der Bohrung, um die sie gruppiert sind, kann dabei so gewählt werden, dass die Mutter die Vias auf der Rückseite der Leiterplatte bedeckt. Alternativ kann aber auch eine Anordnung, bei der die Vias nicht von der Mutter bedeckt werden und diese sich in unmittelbarer Nähe des Umfangs der Mutter befinden, gewählt werden.

Die Vias werden bevorzugt vor einer Durchführung des Schritts a) des Verfahrens, bei dem die Lötpastenschicht gebildet wird, verschlossen. Dies kann durch ein Füllen oder einseitiges Verschließen der Vias erfolgen. Insbesondere werden die Vias auf der Rückseite der Leiterplatte mittels eines Lötstoplacks verschlossen. Das Verschließen der Vias verhindert ein Eindringen von Lot in die Vias, das bei der Ausbildung der Lötverbindung zwischen der Mutter und der Leiterplatte sonst fehlen würde. Eine zu geringe Menge an Lot zwischen der Mutter und der leiterplatte würde die Qualität der Lötverbindung beeinträchtigen.

Eine zusätzliche Stabilisierung der elektrischen Anschlussanordnung kann erreicht werden, wenn die verwendete Leiterplatte dicker als üblich, insbesondere bis zu 50% dicker als üblich ausgebildet ist. Eine Leiterplatte weist standardmäßig eine Dicke von etwa 1,6 mm auf.

Eine Verwendung einer erfindungsgemäßen elektrischen Anschlussanordnung als Anschluss für eine Spannungsversorgung oder eine Stromversorgung, insbesondere eine Hochstromversorgung, ist ideal.

Die Figuren 1 bis 9 sollen die Erfindung beispielhaft erläutern. So zeigt
- Figur 1: einen Querschnitt A - A' durch eine erste elektrische Anschlussanordnung an einer Leiterplatte;
- Figur 2: eine Draufsicht auf die Anordnung gemäß Figur 1;
- Figur 3: eine Ansicht der Anordnung gemäß Figur 1 von unten;
- Figur 4: eine dreidimensionale Ansicht der Anordnung gemäß Figur 1 von oben;
- Figur 5: eine dreidimensionale Ansicht der Anordnung gemäß Figur 3 mit an der Mutter mittels einer Schraube befestigtem Anschlussende eines Anschlusskabels;
- Figur 6: die Anordnung gemäß Figur 5 von unten in einer dreidimensionalen Darstellung;
- Figur 7: einen Querschnitt B - B' durch eine zweite elektrische Anschlussanordnung an einer Leiterplatte;
- Figur 8: eine Draufsicht auf die Anordnung gemäß Figur 7; und
- Figur 9: die Anordnung gemäß Figur 7 von oben in einer dreidimensionalen Darstellung.

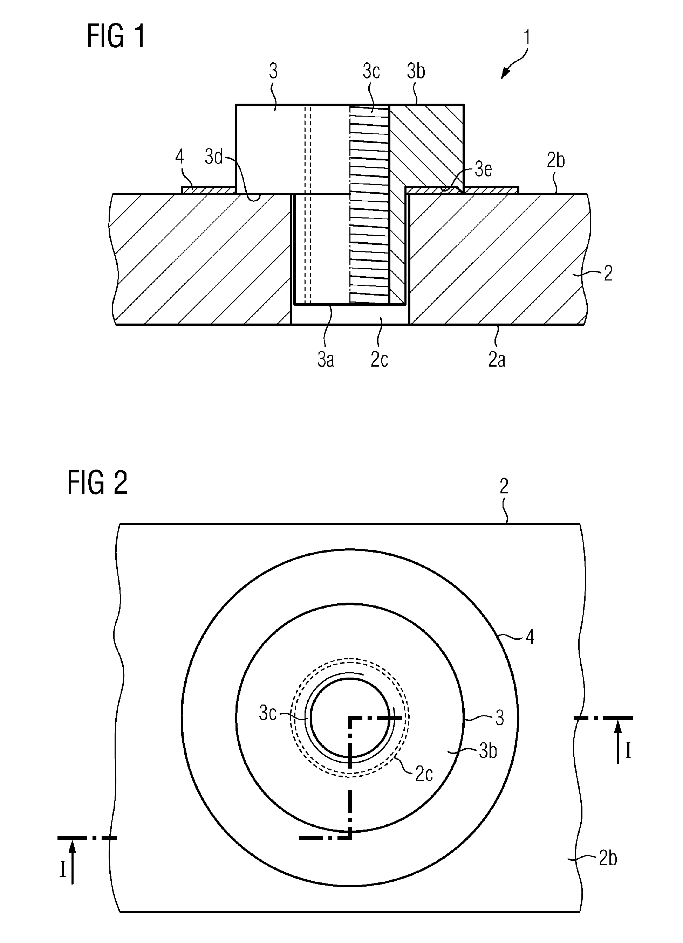

Figur 1 zeigt einen Querschnitt A - A' durch eine erste elektrische Anschlussanordnung 1 an einer Leiterplatte 2. Die Leiterplatte 2 weist eine Vorderseite 2a, eine Rückseite 2b und eine Bohrung 2c auf, die sich durchgehend von der Vorderseite 2a bis zur Rückseite 2b der Leiterplatte erstreckt.

In der Bohrung befindet sich eine Mutter 3 mit kreisförmigem Umfang, welche in die Bohrung 2c einsetzt ist. Die Mutter 3 weist ein erstes Ende 3a, ein zweites Ende 3b, und ein vom ersten Ende 3a zum zweiten Ende 3b durchgehendes Innengewinde 3c auf. Lediglich an dem ersten Ende 3a weist die Mutter 3 einen Außendurchmesser auf, der kleiner ist als ein Durchmesser der Bohrung 2c. Weiterhin weist die Mutter einen Anschlag 3d auf, bis zu welchem die Mutter 3 in die Bohrung 2c gesteckt ist. In dieser Ausführungsform ist der Anschlag 3d hinterdreht, so dass nur der Rand des Abschnittes der Mutter 3, welcher gegenüber dem Durchmesser der Bohrung 2c einen vergrößerten Außendurchmesser aufweist, auf der Rückseite 2b der Leiterplatte 2 bzw. der dort vorhandenen Lötpastenschicht 4 aufliegt. Die Hinterdrehung 3e dient insbesondere zur Aufnahme von geschmolzenem Lot und ist lediglich optional vorhanden. Anstatt einer Hinterdrehung kann auf der Anschlagfläche der Mutter eine Strukturierung zur Aufnahme von Lot, beispielsweise eine Riffelung, vorhanden sein. Der Außendurchmesser des ersten Endes bis zum Anschlag 3d ist so gewählt, dass beim Einsetzen der Mutter 3 in die Bohrung 2c kein Druck aufgewendet werden muss. Die Mutter 3 wird in die Bohrung 2c somit drucklos, insbesondere mittels eines Bestückungsautomaten, eingelegt. Das erste Ende 3a der Mutter 3 ist gegenüber der Vorderseite 2a der Leiterplatte 2 zurückversetzt.

Die auf der Rückseite 2b der Leiterplatte 2 vor dem Einsetzen der Mutter 3 in die Bohrung 2c in einem die Bohrung 2c ringförmig umschließenden Bereich aufgebrachte Lötpastenschicht 4 wurde vor dem Bestücken der Leiterplatte 2 bevorzugt getrocknet.

Beim Reflow-Löten schmilzt das in der Lötpastenschicht 4 enthaltene Lot auf und bildet beim Abkühlen und Erstarren eine feste Verbindung zwischen der Mutter 3 und der Leiterplatte 2 aus. Das geschmolzene Lot kann dabei auch zu einem geringen Teil in den Spalt zwischen der Bohrung 2c und der Mutter 3 gelangen. Die Mutter 3 weist optional an ihren in der Bohrung 2c angeordneten Oberflächen eine Oberflächenstrukturierung auf, die in den Spalt eindringendes Lot aufnimmt und ein Kriechen des Lots im Spalt in Richtung der Vorderseite 2c der Leiterplatte 2 behindert. Eine derartige Oberflächenstrukturierung kann beispielsweise durch eine Riffelung, eine Aufrauhung und dergleichen ausgebildet sein.

Figur 2 zeigt eine Draufsicht auf die elektrische Anschlussanordnung 1 gemäß Figur 1. Gleiche Bezugszeichen wie in Figur 1 bezeichnen gleiche Elemente.

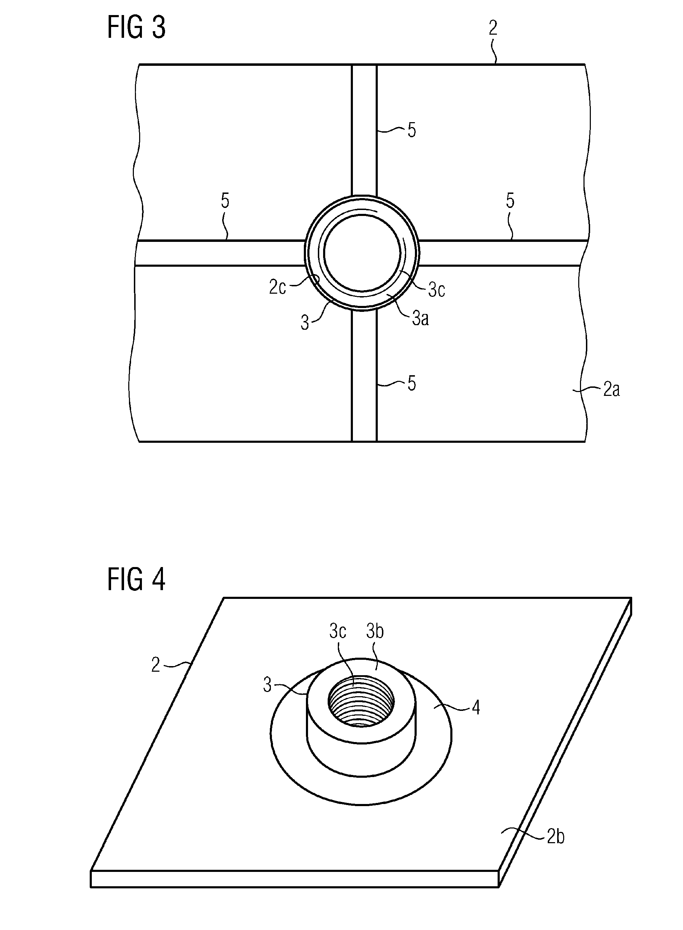

Figur 3 zeigt eine Ansicht der elektrischen Anschlussanordnung 1 gemäß Figur 1 von unten. Dabei ist ein schichtförmiger Leiterzug 5, der auf der Vorderseite 2a der Leiterplatte 2 aufgebracht ist, dargestellt.

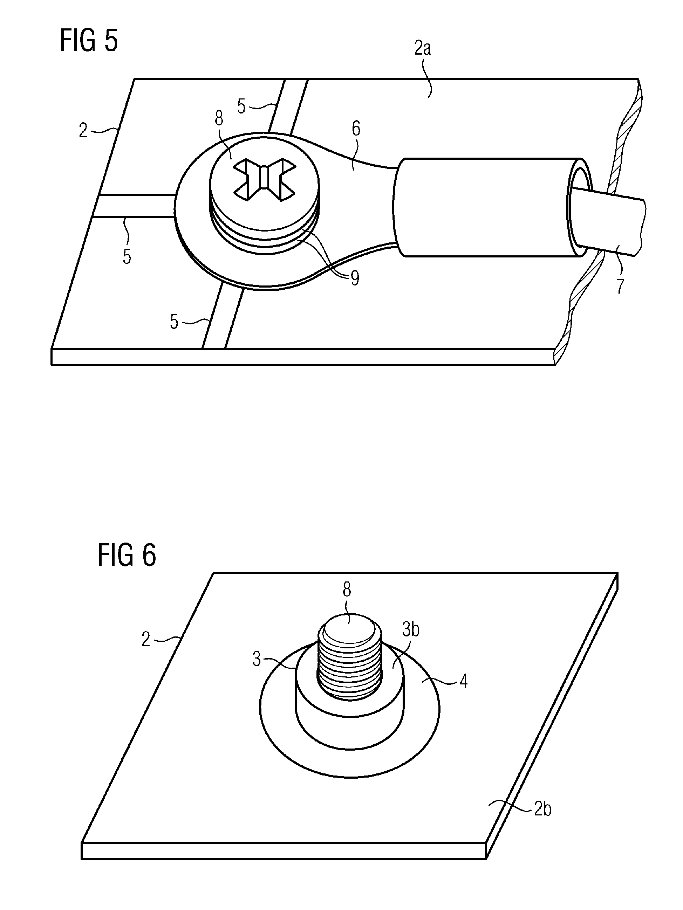

Wird ein Anschlussende eines elektrischen Bauelements auf der Vorderseite 2a der Leiterplatte 2 positioniert und mit der Mutter 3 mittels einer Schraube verschraubt, so wird zwischen dem Anschlusselement und dem Leiterzug 5 eine elektrisch leitende Verbindung ausgebildet (siehe auch Figuren 5 und 6).

Der Leiterzug 5 kann beispielsweise aus Kupfer gebildet sein, das bevorzugt zumindest in einem Bereich um die Bohrung 2c herum, der in Kontakt zum Anschlusselement gelangt, verzinnt ist. Im Inneren der Leiterplatte 2 befinden sich auf unterschiedlichen Ebenen üblicherweise weitere schichtförmige Leiterzüge, die allerdings in den Figuren 1 bis 3 der Übersichtlichkeit halber nicht gesondert dargestellt wurden.

Figur 4 zeigt eine dreidimensionale Ansicht der Anordnung gemäß Figur 1 von oben. Gleiche Bezugszeichen wie in Figur 1 bezeichnen gleiche Elemente.

Figur 5 zeigt eine dreidimensionale Ansicht der elektrischen Anschlussanordnung 1 gemäß Figur 3 mit an der Mutter 3 mittels einer Schraube 8 befestigtem Anschlussende 6 eines Anschlusskabels 7, das beispielsweise zu einem elektrischen Bauelement führt und/oder eine Stromversorgung ausbildet. Das Anschlussende 6 liegt hier in Form eines Kabelschuhs vor, der verzinnt ist. Zur Montage wird das Anschlussende 6 auf der Vorderseite 2a der Leiterplatte 2 positioniert, die Schraube 8 durch den Kabelschuh gesteckt und mit der Mutter 3 verschraubt. Um ein unbeabsichtigtes Lösen der Schaubverbindung zu verhindern, sind Sicherungs- oder Beilagscheiben 9 vorhanden. Insbesondere wird die Schraube 8 mit einem vorbestimmten Drehmoment automatisch angezogen. Zwischen dem Anschlussende 6 und dem Leiterzug 5 wird eine elektrisch leitende Verbindung ausgebildet.

Figur 6 zeigt die Anordnung gemäß Figur 5 von unten in einer dreidimensionalen Darstellung, wobei die aus dem zweiten Ende 3b der Mutter 3 ragende Schraube 8 erkennbar ist.

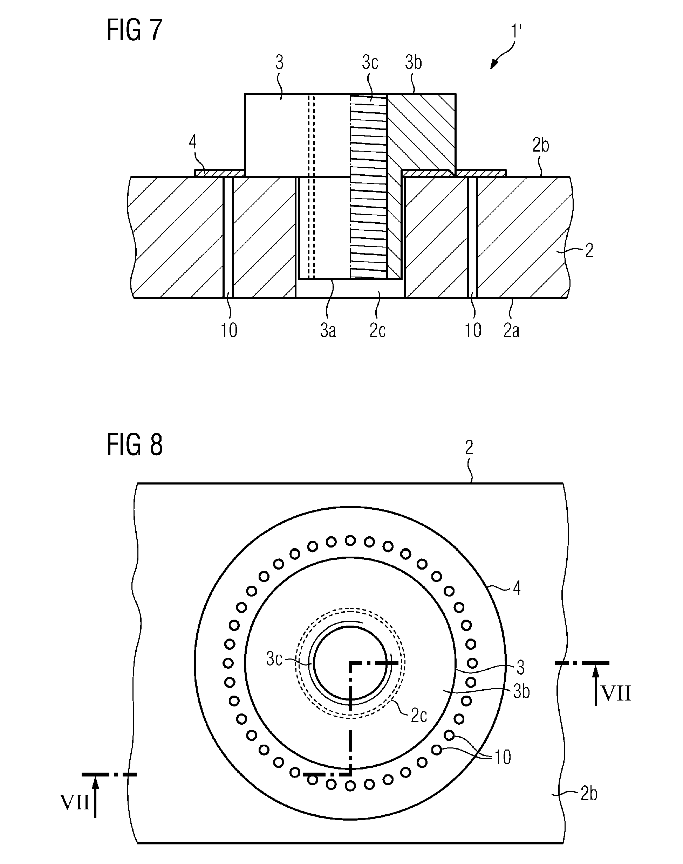

Figur 7 zeigt einen Querschnitt B - B' durch eine zweite elektrische Anschlussanordnung 1' an einer Leiterplatte 1. Im Unterschied zu der in Figur 1 gezeigten Anordnung weist die Leiterplatte 2 eine Anzahl an Vias 10 auf, welche auf einer die Bohrung 2c umringenden Kreisbahn angeordnet sind. Siehe auch Figur 8, die eine Draufsicht auf die Anordnung gemäß Figur 7 zeigt. Die Vias 10 werden bevorzugt vor der Ausbildung der Lötpastenschicht 4 an ihrem der Rückseite 2b der Leiterplatte zugewandten Kanalende mittels eines Lötstoplacks verschlossen, damit beim Reflow-Löten kein Lot in die Vias 10 gelangen kann, was in Folge zu einer Verarmung der Lotstelle an Lot und damit deren Schwächung führen kann. Der verwendete Lötstopplack wurde hier allerdings nicht im Detail dargestellt.

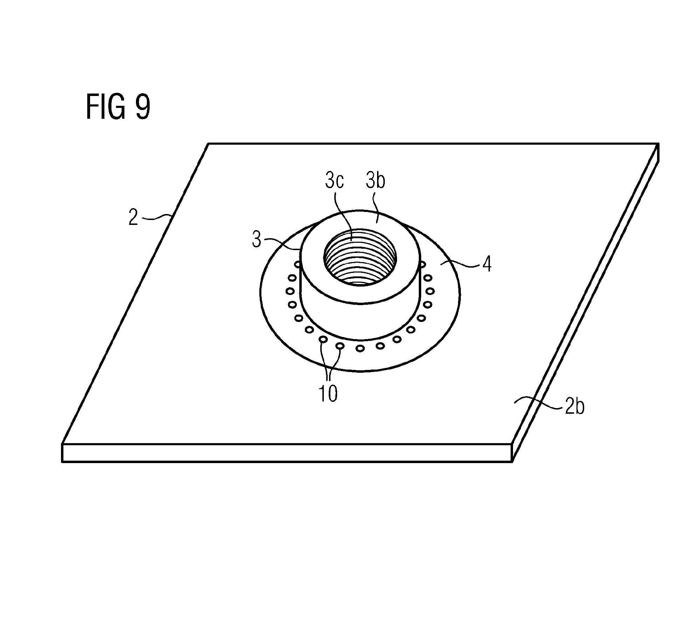

Figur 9 zeigt die Anordnung gemäß Figur 7 von oben in einer dreidimensionalen Darstellung. Gleiche Bezugszeichen wie in Figur 7 bezeichnen gleiche Elemente.

Die Figuren 1 bis 9 zeigen lediglich eine einzelne elektrische Anschlussanordnung an einer Leiterplatte. Es ist aber selbstverständlich, dass eine Leiterplatte mit mehreren elektrischen Anschlussanordnungen ausgebildet sein kann. Weiterhin können beispielsweise auch die dargestellten Leiterzüge auf der Leiterplatte unterschiedlich angeordnet sein. die Art des Anschlussendes verändert werden, sowie die Hinterschneidung im Bereich des Anschlags der Mutter weggelassen werden, ohne den Erfindungsgedanken zu verlassen.

## Patentansprüche

1. Verfahren zur Herstellung mindestens einer elektrischen Anschlussanordnung (1, 1') auf einer Leiterplatte (2), welche mindestens eine von einer Vorderseite (2a) zu einer Rückseite (2b) der Leiterplatte (2) durchgehende Bohrung (2c) aufweist, umfassend folgende Schritte:
a) Aufbringen einer Lötpastenschicht (4) in mindestens einem Bereich der Rückseite (2b) der Leiterplatte (2), welcher die mindestens eine Bohrung (2c) ringförmig umgibt;
b) Bestücken der Leiterplatte (2) mit einer Mutter (3), welche lediglich an einem ersten Ende (3a) ihrer beiden Enden einen Außendurchmesser aufweist, der kleiner ist als ein Durchmesser der Bohrung (2c), derart, dass das erste Ende (3a) in der Bohrung (2c) angeordnet wird; und
c) Ausbilden einer Lötverbindung zwischen der Mutter (3) und der Leiterplatte (2) mittels Reflow-Lötens.

2. Verfahren nach Anspruch 1,
**dadurch gekennzeichnet, dass** das erste Ende (3a) der Mutter (3) bis zu einem Anschlag (3d) an der Mutter (3) in die Bohrung (2c) eingebracht wird, wobei der Anschlag (3d) so angeordnet ist, dass das erste Ende (3a) nach dem Bestücken der Leiterplatte (2) von der Vorderseite (2a) der Leiterplatte (2) zurückversetzt angeordnet wird.

3. Verfahren nach einem der Ansprüche 1 oder 2,
**dadurch gekennzeichnet, dass** nach Schritt c) ein Anschlussende (6) eines elektrischen Bauelements auf der Vorderseite (2a) der Leiterplatte (2) positioniert und mit der Mutter (3) mittels einer Schraube (8) verschraubt wird.

4. Verfahren nach Anspruch 3,
**dadurch gekennzeichnet, dass** das Anschlussende (6) durch einen Kabelschuh gebildet wird.

5. Verfahren nach Anspruch 3 oder Anspruch 4,
**dadurch gekennzeichnet, dass** die Schraube (8) mit der Mutter (3) verklebt wird.

6. Verfahren nach einem der Ansprüche 1 bis 5,
**dadurch gekennzeichnet, dass** die Leiterplatte (2) eine Anzahl an Vias (10) aufweist, welche auf einer die Bohrung (2c) umringenden Kreisbahn angeordnet sind, und dass die Vias (10) vor Schritt a) verschlossen werden.

7. Verfahren nach Anspruch 6,
**dadurch gekennzeichnet, dass** die Vias (10) auf der Rückseite (2b) der Leiterplatte (2) mittels eines Lötstoplacks verschlossen werden.

8. Elektrische Anschlussanordnung (1, 1'), insbesondere gebildet gemäß einem Verfahren nach einem der Ansprüche 1 bis 7, auf einer Leiterplatte (2), welche mindestens eine von einer Vorderseite (2a) zu einer Rückseite (2b) der Leiterplatte (2) durchgehende Bohrung (2c) aufweist, umfassend eine mit der Rückseite (2b) der Leiterplatte (2) verlötete Mutter (3), welche lediglich an einem ersten Ende (3a) ihrer beiden Enden (3a, 3b) einen Außendurchmesser aufweist, der kleiner ist als ein Durchmesser der Bohrung (2c), wobei das erste Ende (3a) in der Bohrung (2c) angeordnet ist und wobei ein zweites Ende (3b) der beiden Enden (3a, 3b) der Mutter (3) auf der Rückseite (2b) der Leiterplatte (2) angeordnet ist.

9. Elektrische Anschlussanordnung nach Anspruch 8,
**dadurch gekennzeichnet, dass** das erste Ende (3a) der Mutter (3) bis zu einem Anschlag (3d) an der Mutter (3) in die Bohrung (2c) eingebracht ist, wobei der Anschlag (3d) so angeordnet ist, dass das erste Ende (3a) der Mutter (3) von der Vorderseite (2a) der Leiterplatte (2) zurückversetzt angeordnet ist.

10. Elektrische Anschlussanordnung Anspruch 8 oder Anspruch 9, **dadurch gekennzeichnet, dass** ein Anschlussende (6) eines elektrischen Bauelements auf der Vorderseite (2a) der Leiterplatte (2) angeordnet und mit der Mutter (6) mittels einer Schraube (8) verschraubt ist.

11. Elektrische Anschlussanordnung nach Anspruch 10,
**dadurch gekennzeichnet, dass** das Anschlussende (6) durch einen Kabelschuh gebildet ist.

12. Elektrische Anschlussanordnung nach Anspruch 10 oder Anspruch 11, **dadurch gekennzeichnet, dass** die Schraube (8) mit der Mutter (3) verklebt ist.

13. Elektrische Anschlussanordnung nach einem der Ansprüche 8 bis 12, **dadurch gekennzeichnet, dass** die Leiterplatte (2) eine Anzahl an Vias (10) aufweist, welche auf einer die Bohrung (2c) umringenden Kreisbahn angeordnet sind.

14. Elektrische Anschlussanordnung nach Anspruch 13,
**dadurch gekennzeichnet, dass** die Vias (10) auf der Rückseite (2b) der Leiterplatte (2) mittels eines Lötstoplacks verschlossen sind.

15. Verwendung einer elektrischen Anschlussanordnung (1, 1') nach einem der Ansprüche 8 bis 14 als Anschluss für eine Spannungsversorgung oder eine Stromversorgung, insbesondere eine Hochstromversorgung.
